**Europäisches Patentamt**

(19) **European Patent Office**

**Office européen des brevets**

(11) Veröffentlichungsnummer: **0 007 015**
**B1**

(12) **EUROPÄISCHE PATENTSCHRIFT**

(45) Veröffentlichungstag der Patentschrift: **05.10.83**

(51) Int. Cl.³: **H 01 L 23/42, H 01 L 23/46**

(21) Anmeldenummer: **79102007.6**

(22) Anmeldetag: **18.06.79**

(54) **Vorrichtung zum Kühlen von Halbleiterchips mit monolithisch integrierten Schaltungen.**

(30) Priorität: **11.07.78 US 923592**

(43) Veröffentlichungstag der Anmeldung:
**23.01.80 Patentblatt 80/2**

(45) Bekanntmachung des Hinweises auf die Patenterteilung:
**05.10.83 Patentblatt 83/40**

(84) Benannte Vertragsstaaten:
**DE FR GB**

(56) Entgegenhaltungen:
**US - A - 3 573 574**
**US - A - 3 852 805**

**IBM TECHNICAL DISCLOSURE BULLETIN, Band
20, April 1978, New York U. P. HWANG et al.
"Liquid encapsulated conduction module",
Seiten 4780—4781**

(73) Patentinhaber: **International Business Machines
Corporation
Old Orchard Road
Armonk, N.Y. 10504 (US)**

(72) Erfinder: **Oktay, Sevgin
097 Fox Run
Poughkeepsie, New York 12603 (US)**
Erfinder: **Torgersen, Gerard Joseph
29 Sans Souci Drive
Pawling, New York 12564 (US)**
Erfinder: **Wong, Alexander Chun-Bong
32 Daisy Lane
Wappingers Falls, New York 12590 (US)**

(74) Vertreter: **Neuland, Johannes, Dipl.-Ing.
Schönaicher Strasse 220
D-7030 Böblingen (DE)**

## Vorrichtung zum Kühlen von Halbleiterchips mit monolithisch integrierten Schaltungen

Die Erfindung bezieht sich auf eine Vorrichtung zum Kühlen von Halbleiterchips mit monolithisch integrierten Schaltungen. Sie geht aus von einer bekannten Vorrichtung zum Kühlen von Halbleiterchips (DE—OS 22 31 597). Bei ihr sind die Halbleiterchips an einer Trägerplatte in einem Behälter angeordnet, der mit einer Siedeflüssigkeit gefüllt ist. In der Siedeflüssigkeit wird die abzuführende Wärme durch Gasblasen von einem erhitzten Halbleiterchip zu einem Wärmetauscher übertragen. Dieser besteht aus einem von Kühlluft durchströmten Kanal, in welchem mehrere Behälter angeordnet sind, welche die Siedeflüssigkeit und die Halbleiterchips enthalten. Zum Zweck einer besseren Wärmeübertragung an den Wärmetauscher sind an den Innen- und Außenflächen einer Behälterwand Kühlrippen vorgesehen.

Mit der bekannten Einrichtung läßt sich eine bestimmte Wärmemenge abführen, wenn die Temperatur des Halbleiterchips einen vorgegebenen Wert nicht überschreiten darf.

Es sind ferner Vorrichtungen zur Kühlung von Halbleiterchips bekannt (IBM Technical Disclosure Bulletin, Vol. 20, Nr. 11B, April 1978, Seiten 4780—4781), bei welcher die Wärmeübertragung der in einer Kühlflüssigkeit angeordneten Halbleiterchips dadurch beschleunigt wird, daß an deren Oberfläche wärmeleitende Kolben aufgesetzt werden, die von der Kühlflüssigkeit umgeben sind und die jeweils einen zur Oberfläche der Kühlflüssigkeit senkrechten durchgehenden Kanal aufweisen. Auch bei dieser bekannten Einrichtung ist die von den Halbleiterchips zu einem Wärmetauscher abführbare Wärme auf einen Wert begrenzt, der für hochintegrierte Halbleiterchips nicht befriedigt.

Es ist auch ein Verfahren bekannt (US—PS 4 050 507), den Siedevorgang einer Kühlflüssigkeit, in welcher Halbleiterchips zur Kühlung angeordnet sind, zu beschleunigen. Das Verfahren besteht darin, daß durch Elektronen- oder Laserstrahlbearbeitung der Rückseite eines in der Kühlflüssigkeit befindlichen Halbleiterchips Löcher kleinsten Durchmessers eingefügt werden. Diese bewirken die Anlagerung von Luftmolikühlen, die nach dem Einsetzen eines Halbleiterchips in die Kühlflüssigkeit nicht aus dieser entweichen können. Bei der Erwärmung des Halbleiterchips ergeben sich über diesen Löchern Blasenkeime, welche den Siedevorgang schon bei niedrigeren Temperaturen einleiten. Die an der Chipoberfläche verdampfende Kühlflüssigkeit erzeugte durch die Einwirkung der Blasenkeime Dampfblasen, die zur Oberfläche der Kühlflüssigkeit aufsteigen. Unterhalb der Siedetemperatur der Kühlflüssigkeit ist die Auftriebskraft dieser Dampfblasen jedoch so gering, daß sie die Oberfläche der Kühlflüssigkeit nicht durchbrechen können.

Es ist die Aufgabe der vorliegenden Erfindung, eine Vorrichtung zum Kühlen von Halbleiterchips mit monolithisch integrierten Schaltungen so auszubilden, daß eine verbesserte Wärmeübertragung zwischen den Halbleiterchips und einem Wärmetauscher stattfinden kann. Diese Aufgabe wird bei einer Vorrichtung gemäß dem Oberbegriffen der Ansprüche 1 und 2 durch die in denen Kennzeichen angeführten Merkmale gelöst.

Diese Merkmale haben den Vorteil, daß in der Siedeflüssigkeit an einer Halbleiterfläche durch Blasenkeime erzeugte Dampfblasen durch Kanäle bestimmter Abmessungen in Auftriebsrichtung geführt und dadurch stabilisiert werden.

Ausführungsbeispiele der Erfindung werden in Verbindung mit den Zeichnungen näher erläutert, von denen zeigen:

Fig. 1 mit der Rückseite von Halbleiterchips verbundener Wärmeleiter, in welchem Ausnehmungen angeordnet sind,

Fign. 2 u. 3 einen zwischen einem Halbleiterchip und der Trägerplatte angeordneten Wärmeleiter, in welchem Kanäle angeordnet sind,

Fign. 4 u. 5 Kühlsysteme, die mit einem Behälter verbunden sind, der in einer Kühlflüssigkeit angeordnete Halbleiterchips enthält,

Fig. 6 eine verbesserte Ausführungsform der in den Fign. 1A bis 5 gezeigten Kühlvorrichtung für Halbleiterchips,

Fig. 7 verschiedene Diagramme der zwischen einem Halbleiterchip und einem Wärmetauscher in Abhängigkeit von der Temperatur des Halbleiterchips erzielbaren Wärmeübertragung für verschiedene Kühlsysteme,

Fig. 8 verschiedene Diagramme der zwischen einem Halbleiterchip und einem Wärmetauscher in Abhängigkeit von der Temperatur der Halbleiterchips erzielbaren Wärmeübertragung bei Benutzung verschiedener Wärmesenken,

Fig. 9 zwei Diagramme der zwischen einem Halbleiterchip und einem Wärmetauscher in Abhängigkeit von der Temperatur des Halbleiterchips erzielbaren Wärmeübertragung für zwei Kühlstrukturen mit senkrechten Kanälen.

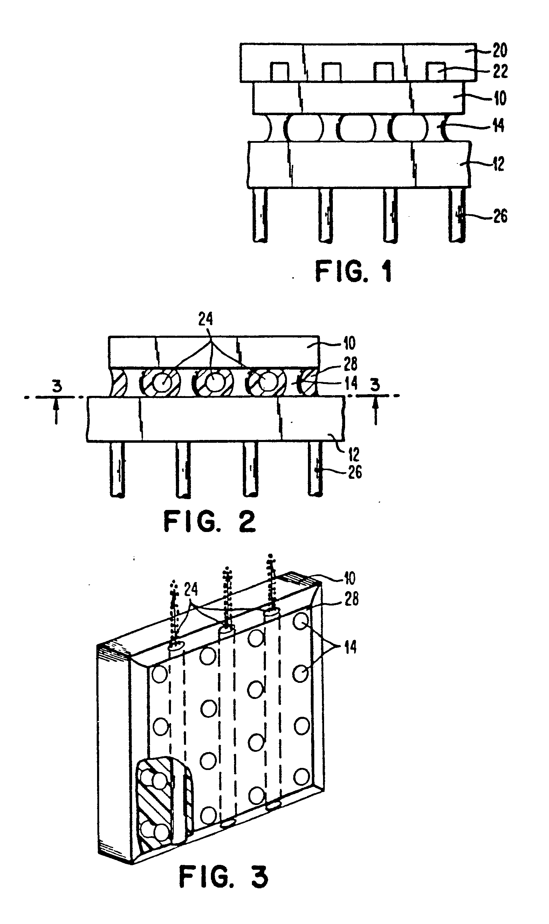

Das in Fig. 1 als Halbleiterchip ausgebildete Bauteil 10 ist durch Lötverbindungen 14 mit einer Trägerplatte 12 verbunden. Die Lötverbindungen 14, welche die elektrische Verbindung zwischen den Schaltkreisen des Bauteils 10 und den Anschlußkontakten 26 der Trägerplatte herstellen, sorgen auch dafür, daß das Bauteil 10 von der Trägerplatte 12 einen Abstand aufweist. Die der Trägerplatte 12 abgewandte Seite des Bauteils 10 ist mit einem blockförmigen Wärmeleiter 20 verbunden, in welchem Ausnehmungen 22 angeordnet sind. Die Verbindung zwischen dem Bauelement 10 und dem Wärmeleiter 20 erfolgt durch ein Beschichtungsmaterial, wie z. B. eine eutektische Gold-Silicium-Legierung oder eine Chrom-Kupfer-Legierung. Die Ausnehmungen 22, die einen rechteckförmigen Querschnitt aufweisen, grenzen direkt an die Oberfläche des Bauteils 10.

Bei der Ausführungsform nach Fig. 2 sind zwischen den Lötverbindungen 14, welche das Bauteil 10 mit der Trägerplatte 12 verbinden, Kanäle 24 von ca. 0,1 mm Durchmesser angeordnet. Die Kanäle werden dadurch gebildet, daß an der Oberfläche des Bauteils 10 eine Schicht 28 aus mikrokristallinem Wachs aufgetragen wird, in welches Fasern eingelegt werden. Nach dem Aushärten der Wachsschicht werden die Fasern aus der Wachsschicht herausgezogen, wodurch die Kanäle 24 gebildet werden. Das als Halbleiterchip ausgebildete Bauteil 10 wird sodann durch Lötverbindungen 14 mit der Trägerplatte 12 verbunden. Gemäß der Darstellung nach Fig. 3 sind die Kanäle 24 in der Betriebsstellung innerhalb eines mit einer Siedeflüssigkeit gefüllten Behälters senkrecht angeordnet, wodurch in den Kanälen 24, welche die Siedeflüssigkeit aufnehmen, die Bildung von Blasenkeimen für die Wärmeübertragung begünstigt wird.

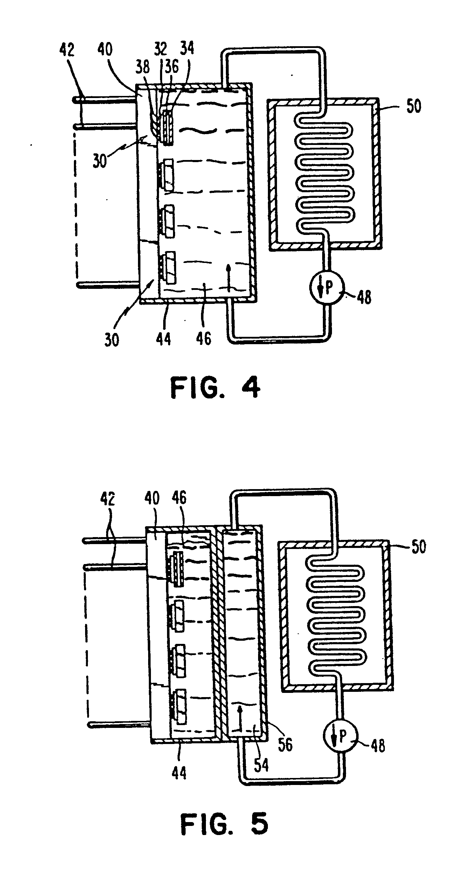

Die in Fig. 4 dargestellte Vorrichtung zur Kühlung erhitzter Bauteile, insbesondere von Halbleiterstrukturen 30, zeigt die Anordnung mehrerer Halbleiterchips 32, die jeweils mit einem Wärmeleiter 34 verbunden sind. Dieser enthält jeweils die Kanäle 36. Lötverbindungen 38 verbinden die Halbleiterchips 32 elektrisch und mechanisch mit der Trägerplatte 40. Diese trägt die Anschlußstifte 42. Der Behälter 44 enthält eine Kühlflüssigkeit 46. Die Kühlflüssigkeit 46, die z. B. aus einem Perfluor-n-Hexan besteht, hat einen niedrigen Siedepunkt. In dem Behälter 44 wird ein konstanter Druck aufrechterhalten, wodurch der Siedepunkt bei einer bestimmten Temperatur gehalten wird. Die Kühlflüssigkeit 46, für welche durch die Pumpe 48 ein Kreislauf zwischen dem Behälter 46 und dem Wärmetauscher 50 hergestellt wird, verdampft teilweise durch die Erhitzung der Halbleiterchips 32. Im Wärmetauscher 50 wird der so entstandene Dampf wieder verflüssigt.

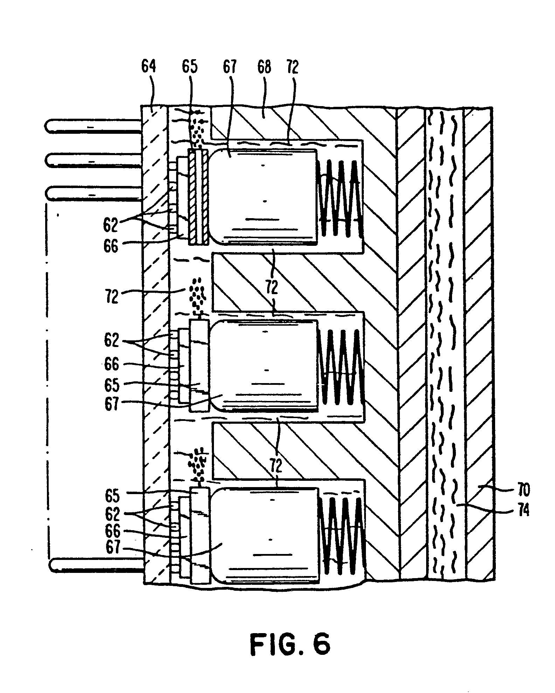

Die in Fig. 5 dargestellte Vorrichtung für die Kühlung erhitzter Bauteile unterscheidet sich von der Ausführung nach Fig. 4 dadurch, daß der Behälter 44, der die Siedeflüssigkeit enthält, mit einem Behälter 56 verbunden ist. Dieser enthält eine Kühlflüssigkeit 54, die mit dem Wärmetauscher 50 in Verbindung steht.

Die in Fig. 6 dargestellte Vorrichtung zur Kühlung von erhitzten Bauteilen zeigt die Halbleiterchips 66, die durch die Lötverbindungen 62 elektrisch und mechanisch mit der Trägerplatte 64 verbunden sind. Die Halbleiterchips 66 sind an der von der Trägerplatte 64 angewandten Seite mit Wärmeleitern 65 verbunden, in welchen durchgehende, mit der Siedeflüssigkeit 72 gefüllte Kanäle vorgesehen sind. Die Kanäle sind bezüglich der Oberfläche der Siedeflüssigkeit 72 senkrecht angeordnet. Dadurch können die in den Kanälen gebildeten Blasen durch ihren Auftrieb in der Siedeflüssigkeit ungehindert aufsteigen. Ein von der Siedeflüssigkeit umgebener, wärmeleitender Kolben 67 ist jeweils an der Rückseite eines Wärmeleiters 65 durch die Wirkung einer Feder elastisch aufgesetzt. Die wärmeleitenden Kolben werden gekühlt durch eine Platte 70, die von einer Kühlflüssigkeit 74 durchströmt ist.

Die anhand der Ausführungsbeispiele beschriebenen Wärmeleiter, die mit den erhitzten Bauteilen verbunden sind, bestehen aus einem gut wärmeleitenden Material, wie z. B. Kupfer, Silicium, Molybdän usw. Die in den Wärmeleitern vorgesehenen Kanäle, welche die Länge L und den Durchmesser D haben, zeigen für die Ausführungsbeispiele der Fign. 1A und 1B ein Verhältnis L/D~4 bis 7. Bei dem Ausführungsbeispiel der Fign. 2 und 3 ist das Verhältnis L/D~30 bis 70.

Beispiel 1

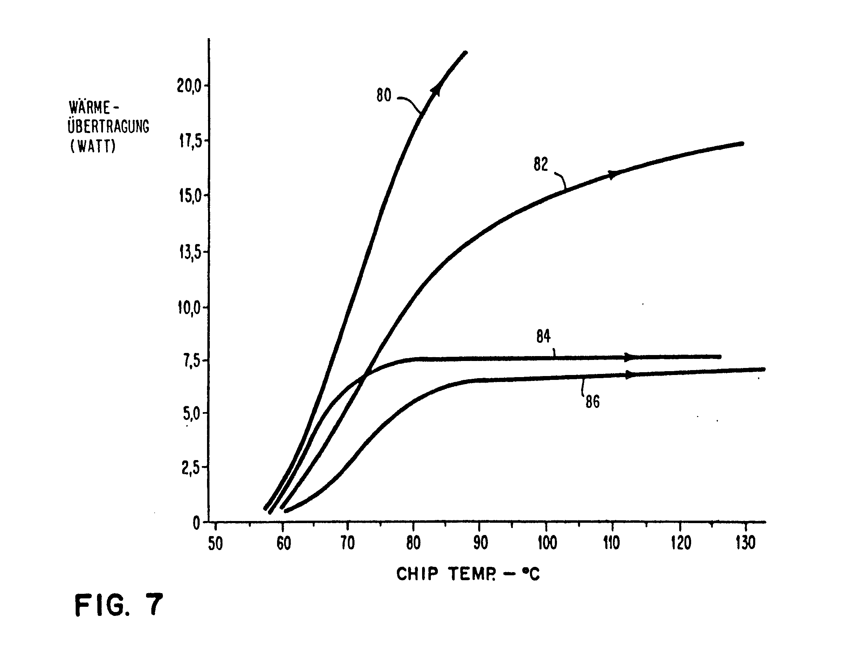

Ein Siedeversuch wurde mit einer Kühlvorrichtung durchgeführt, bei welcher ein 4,6 mm×4,6 mm Halbleiterchip gemäß der Ausführungsform nach Fig. 1A auf einer Trägerplatte mit den Abmessungen 25 mm×25 mm montiert ist. Der Wärmeleiter bestand aus Kupfer mit den Abmessungen 6,0 mm×6,0 mm×1,5 mm, der vier Kanäle enthält, die einen Durchmesser von 1 mm aufweisen. Die Verbindung zwischen dem Halbleiterchip und dem Wärmeleiter wurde durch zwei Tropfen von Silberepoxyharz hergestellt, die zwischen der Kante des Wärmeleiters und dem Halbleiterchip eingeführt und unter einem Gewicht von 50 g ausgehärtet wurden. Die aus dem Halbleiterchip und dem Wärmeleiter mit Kanälen bestehende Anordnung wurde sodann in einem Behälter eingesetzt, der mit Perfluor-n-Hexan gefüllt war. Der Behälter wurde sodann auf 54°C erhitzt und gasdicht verschlossen. Alle Versuche wurden anhand des gasdicht verschlossenen Behälters bei ungefähr konstantem Druck von ca 1 fle (1 Atmosphäre) durchgeführt, wobei die Kapazität des Wärmetauschers an die Verlustwärme des Halbleiterchips angepaßt war. Am Halbleiterchip angebrachte, mit einer Vorspannung betriebene Dioden dienten als Temperaturfühler. Die in Fig. 7 dargestellte Kurve 80 ziegt die von einem Halbleiterchip, das mit einem Wärmeleiter verbunden ist, der Kanäle enthält, abführbare Wärme als Funktion der Temperatur des Halbleiterchips. Die Kurve 82 gilt für ein mit Nickel-Eisen-Dendriten versehenes Halbleiterchip. Die Kurve 84 gilt für ein Halbleiterchip, das durch Sandstrahlen und Ätzen mit Kalilauge behandelt wurde. Die Kurve 86 gilt für ein unbehandeltes Halbleiterchip. Aus den Darstellungen nach Fig. 7 geht hervor, daß bei Anwendung eines Wärmeleiters aus Kupfer, der Kanäle aufweist, die abführbare Wärme 20 W überschreitet, ohne daß sich ein Dampffilm ausbildet.

Beispiel 2

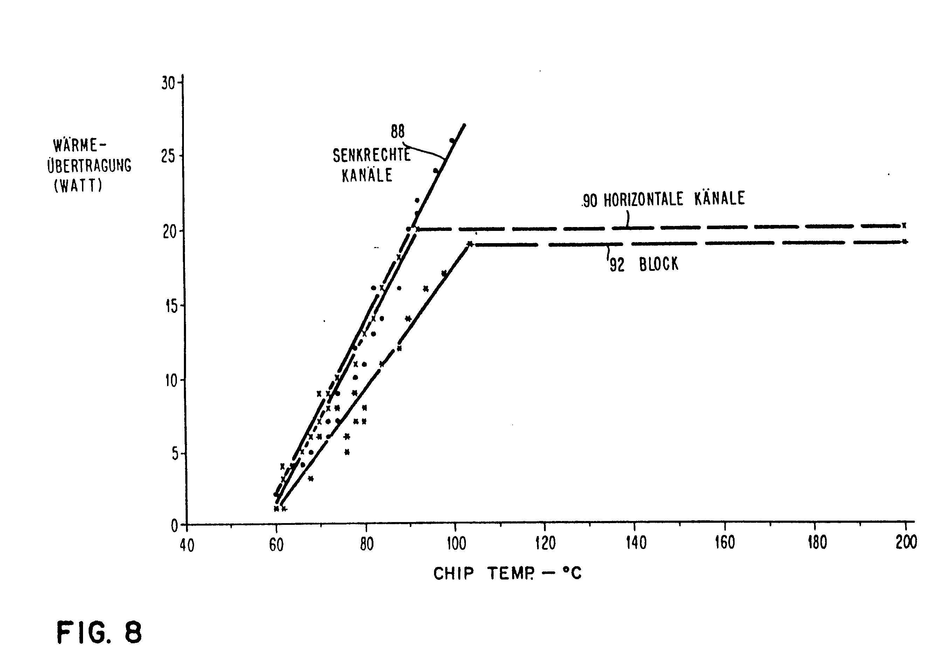

Die Fig. 8 zeigt die Gegenüberstellung der Wirkungen der Kühlvorrichtung bei Kanälen, die in den Wärmeleitern senkrecht und solchen, die horizontal angeordnet sind. Die Kurve 88 zeigt die abführbare Wärme als Funktion der Temperatur des Halbleiterchips bei Kanälen, die im Wärmeleiter der Kühlvorrichtung bezüglich deren Standebene senkrecht angeordnet sind. Die Kurve 90 zeigt die abführbate Wärme als Funktion der Temperatur des Halbleiterchips bei Kanälen, die im Wärmeleiter bezüglich der Standebene des Behälters der Kühlvorrichtung horizontal angeordnet sind. Die Kurve 92 zeigt die abführbare Wärme als Funktion der Temperatur des Halbleiterchips, wenn der Wärmeleiter lediglich als ein Block ohne Kanäle ausgeführt ist.

Beispiel 3

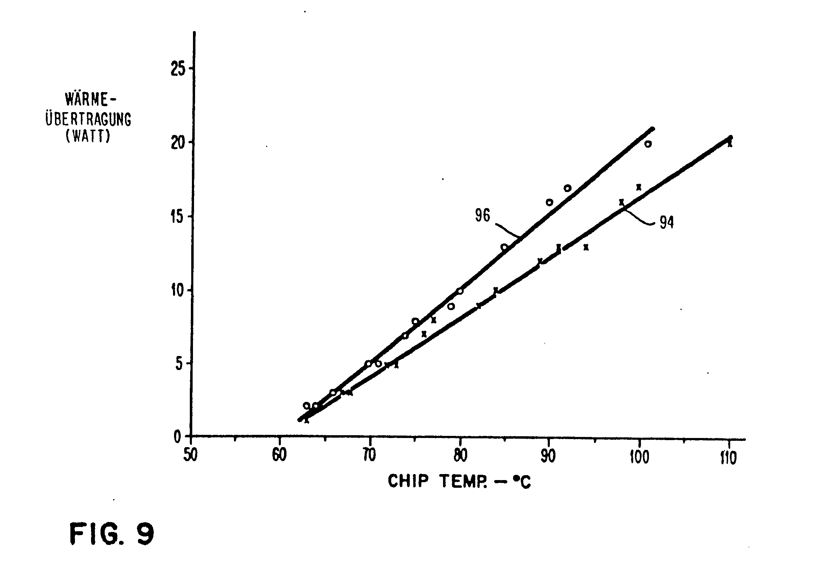

Die Fig. 9 zeigt die abführbare Wärme als Funktion der Temperatur des Halbleiterchips bei Kühlvorrichtungen, deren Wärmeleiter, die mit den erhitzten Bauteilen verbunden sind, gemäß den Darstellungen nach den Fign. 1A und 1B ausgeführt sind. Die Kurve 94 zeigt den Verlauf der abzuführenden Wärme als Funktion der Temperatur des Halbleiterchips bei einer Vorrichtung nach Fig. 1A und die Kurve 96 zeigt die abführbare Wärme als Funktion der Temperatur des Halbleiterchips bei einer Vorrichtung nach Fig. 1B.

**Patentansprüche**

1. Vorrichtung zum Kühlen von Halbleiterschips mit monolithisch integrierten Schaltungen, bei der die Halbleiterchips über Lötverbindungen elektrisch und mechanisch mit einer Trägerplatte verbunden sind, die eine Wand eines mit einer als Kühlflüssigkeit dienenden Siedeflüssigkeit gefüllten Behälters bildet, die die von der Halbleiterchips abzuführende Wärme über Gasblasen zu einem Wärmeaustauscher überträgt, dadurch gekennzeichnet, daß der Raum zwischen der Trägerplatte, den Lötverbindungen und dem Halbleiterchip mit einem mikrokristallinen Wachs ausgefüllt ist, das senkrecht zur Oberfläche der Siedeflüssigkeit verlaufende Kanäle für die Siedeflüssigkeit aufweist.

2. Vorrichtung zum Kühlen von Halbleiterchips mit monolithisch integrierten Schaltungen, bei der die zwei Hauptflächen aufweisenden Halbleiterchips über Lötverbindungen elektrisch und mechanisch mit einer Trägerplatte verbunden sind, die eine Wand eines mit einer als Kühlflüssigkeit dienenden Siedeflüssigkeit gefüllten Behälters bildet, die die von den Halbleiterchips abzuführende Wärme über Gasblasen zu einem Wärmeaustauscher überträgt und auf der der Trägerplatte abgewandten Hauptfläche mit einem festen Wärmeleiter versehen sind, dadurch gekennzeichnet, daß der Wärmeleiter (20) mit Ausnehmungen versehen ist, die zusammen mit der einen Hauptfläche des Halbleiterchips senkrecht zur Oberfläche der Siedeflüssigkeit angeordnete Kanäle (22) bilden.

3. Vorrichtung zum Kühlen nach Anspruch 1, dadurch gekennzeichnet, daß das Verhältnis der Länge L der Kanäle zu deren Durchmesser D im Bereich von 30 bis 70 liegt.

4. Vorrichtung zum Kühlen nach Anspruch 2, dadurch gekennzeichnet, daß das Verhältnis der Länge L der Kanäle zu deren Durchmesser D im Bereich von 4 bis 7 liegt.

5. Vorrichtung zum Kühlen nach den Ansprüchen 1 bis 4, dadurch gekennzeichnet, daß als Siedeflüssigkeit Perfluor-n-Hexan dient.

**Revendications**

1. Dispositif pour le refroidissement de pastilles semi-conductrices comportant des circuits intégrés monolithiques, dans lequel lesdites pastilles semi-conductrices sont reliées électriquement et mécaniquement, à travers des jonctions obtenues par soudure, à une plaque-support qui constitue une des parois d'un conteneur rempli d'un fluide porté à ébullition servant de caloporteur et qui transfère, sous la forme de bulles de gaz, la chaleur dégagée par lesdites pastilles semi-conductrices, caractérisé en ce que le vide existant entre ladite plaque-support, lesdites jonctions obtenues par soudure et ladite pastille semi-conductrice est comblé par une cire microcristalline qui comporte des canaux disposés de façon perpendiculairement à la surface dudit fluide bouillant et destinés à recevoir ledit fluide.

2. Dispositif pour le refroidissement de pastilles semi-conductrices comportant des circuits intégrés monolithiques, dans lequel lesdites pastilles semi-conductrices qui comportant deux faces principales, sont reliées électriquement et mécaniquement, à travers des jonctions obtenues par soudure, à une plaque-support qui constitue une des parois du conteneur rempli d'un fluide porté à ébullition servant de caloporteur et transférant, sous la forme de bulles de gaz, la chaleur dégagée par lesdites pastilles semi-conductrices, et, un conducteur de chaleur étant situé sur la face principale dirigée dans le sens opposé à ladite plaque-support, caractérisé en ce que ledit conducteur de chaleur (20) comporte des cavités qui, associées à une des faces principales de la pastille semi-conductrice, constituent des canaux (22) disposés de façon perpendiculaire à la surface dudit fluide en ébullition.

3. Dispositif de refroidissement selon la revendication 1, caractérisé en ce que le rapport de la longueur L desdits canaux sur leur diamètre D varie entre 30 et 70.

4. Dispositif de refroidissement selon la revendication 2, caractérisé en ce que le rapport de la longeuer L desdits canaux sur leur diamètre D varie entre 4 et 7.

5. Dispositif de refroidissement selon l'une quelconque des revendications 1 à 4, caractérisé en ce que ledit caloporteur est du perfluoro-n-héxane.

## Claims

1. Device for cooling semiconductor chips with monolithically integrated circuits, where the semiconductor chips are electrically and mechanically connected via solder connections to a carrier plate which forms a wall of a container filled with a boiling fluid used as a coolant transferring the heat to be eliminated from the semiconductor chips, via gas bubbles to a heat exchange, characterized in that the space between the carrier plate, the solder connections, and the semiconductor chip is filled with a microcrystalline wax having channels for the boiling fluid which extend vertically to the level of the boiling fluid.

2. Device for cooling semiconductor chips with monolithically integrated circuits, where the semiconductor chips having two main surfaces are connected via solder connections electrically and mechanically to a carrier plate which forms a wall of a container filled with a boiling fluid used as a coolant, which transfers the heat to be eliminated from the semiconductor chips via gas bubbles to a heat exchange, and which on the main surface facing away from the carrier plate is equipped with a fixed heat conductor, characterized in that the heat conductor (20) has recesses which together with the one main surface of the semiconductor chip forms channels (22) arranged vertically to the level of the boiling fluid.

3. Device for cooling as claimed in claim 1, characterized in that the ratio of length L of the channels to their diameter D ranges from 30 to 70.

4. Device for cooling as claimed in claim 2, characterized in that the ratio of length L of the channels to their diameter D ranges from 4 to 7.

5. Device for cooling as claimed in any one of claims 1 to 4, characterized in that as cooling fluid perfluoro-n-hexane is used.

FIG. 1

FIG. 2

FIG. 3

FIG. 4

FIG. 5

FIG. 6

FIG. 7

FIG. 8

0 007 015

FIG. 9